(19) **Europäisches Patentamt / European Patent Office / Office européen des brevets**

(11) **EP 2 304 787 B1**

(12) **FASCICULE DE BREVET EUROPEEN**

(45) Date de publication et mention de la délivrance du brevet:
**19.10.2011 Bulletin 2011/42**

(21) Numéro de dépôt: **09765984.1**

(22) Date de dépôt: **28.04.2009**

(51) Int Cl.:
***H01L 21/762*** *(2006.01)*

(86) Numéro de dépôt international:
**PCT/FR2009/000502**

(87) Numéro de publication internationale:
**WO 2009/153422 (23.12.2009 Gazette 2009/52)**

(54) **TRAITEMENT DE SURFACE PAR PLASMA D'AZOTE DANS UN PROCÉDÉ DE COLLAGE DIRECT**

STICKSTOFFPLASMA-OBERFLÄCHENBEHANDLUNG IN EINEM DIREKTBINDUNGSVERFAHREN

NITROGEN-PLASMA SURFACE TREATMENT IN A DIRECT BONDING METHOD

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **26.05.2008 FR 0802833**

(43) Date de publication de la demande:
**06.04.2011 Bulletin 2011/14**

(73) Titulaire: **Commissariat à l'Énergie Atomique et aux Énergies Alternatives 75015 Paris (FR)**

(72) Inventeurs:
• **MORICEAU, Hubert**
  **F.-38120 Saint-Egrève (FR)**
• **MORALES, Christophe**
  **F-38220 St Pierre de Mesage (FR)**
• **RIEUTORD, François**
  **F-38120 Saint-Egrève (FR)**
• **VENTOSA, Caroline**
  **34150 Gignac (FR)**
• **CHEVOLLEAU, Thierry**
  **F-38000 Grenoble (FR)**

(74) Mandataire: **Dubreu, Sandrine**
  **Cabinet Hecké**
  **10, rue d'Arménie**
  **Europole**
  **BP 1537**
  **38025 Grenoble Cedex 1 (FR)**

(56) Documents cités:
**US-A- 5 503 704**

• ZHU M ET AL: "Formation of silicon on plasma synthesized SiOxNy and reaction mechanism" APPLIED SURFACE SCIENCE, ELSEVIER, AMSTERDAM, NL, vol. 243, no. 1-4, 30 avril 2005 (2005-04-30), pages 89-95, XP004871791 ISSN: 0169-4332
• BENGTSSON S ET AL: "ROOM TEMPERATURE WAFER BONDING OF SILICON, OXIDIZED SILICON AND CRYSTALLINE QUARTZ" JOURNAL OF ELECTRONIC MATERIALS, WARRENDALE, PA, US, 19 septembre 1999 (1999-09-19), pages 1-27, XP001159604 ISSN: 0361-5235

EP 2 304 787 B1

**Description**

**Domaine technique de l'invention**

L'invention concerne un procédé de collage direct de deux plaques comprenant chacune en surface une couche mince en oxyde de silicium ou en silicium.

**État de la technique**

Le principe du collage par adhérence moléculaire ou collage direct est basé sur la mise en contact direct de deux surfaces, sans utilisation d'un matériau spécifique tel qu'une colle, une cire, un métal à basse température de fusion... Les surfaces destinées à être mises en contact peuvent être hydrophiles ou hydrophobes.

Des surfaces hydrophobes peuvent, par exemple, être les surfaces libres de deux plaquettes (ou substrats) en silicium exemptes d'oxyde de silicium, tandis que des surfaces hydrophiles peuvent, par exemple, être les surfaces libres de deux plaques en silicium comportant chacun une couche mince d'oxyde de silicium.

Le procédé de collage par adhérence moléculaire nécessite, par ailleurs, que les surfaces à coller soient suffisamment lisses, exemptes de particules ou de contamination, qu'elles présentent une chimie de surface adaptée et qu'elles soient suffisamment rapprochées pour permettre d'initier un contact. Dans ce cas, les forces attractives entre les deux surfaces sont assez élevées pour provoquer l'adhérence moléculaire.

Les collages sont, généralement, réalisés à température ambiante et à pression ambiante, après un nettoyage chimique des surfaces. Cependant, un traitement thermique ultérieur, par exemple à une température de l'ordre de 1000°C, est souvent réalisé pour renforcer les énergies de collage. Or, dans un très grand nombre d'applications, les étapes de traitement thermique à une telle température ne sont pas admises.

Des procédés de collage, ne nécessitant pas de traitements thermiques à haute température, ont déjà été proposés. Ils comprennent en général une étape d'activation de surface.

À titre d'exemple, P. Amirfeiz et al. dans l'article « Formation of silicon structures by plasma-activated wafer bonding » (Journal of the Electrochemical Society, 147 (7) 2693-2698), ont étudié les effets d'une activation du silicium, de l'oxyde de silicium et du quartz cristallin par un plasma d'oxygène ou par un plasma d'argon, en vue d'un collage direct à température ambiante. Les structures collées, activées par un plasma d'oxygène ou un plasma d'argon, présentent des énergies de surface élevées, comparables à celles obtenues pour des structures collées soumises à une activation par voie humide classique avant le collage et à un traitement thermique à haute température (entre 600°C et 800°C) après la mise en contact. L'exposition au plasma d'oxygène ou au plasma d'argon est réalisée à l'aide d'un dispositif de type RIE/ICP (gravure réactive ionique/plasma couplé par induction).

Dans l'article « Effects of Plasma Activation on Hydrophilic Bonding of Si and SiO2 » de T. Suni et al. (« Journal of the Electrochemical Society, 149 (6) G348-G651 (2002)), un mode de gravure ionique réactive (également appelé RIE) est utilisé en association avec une activation par plasma d'azote, d'argon ou d'oxygène pour réaliser un collage à basse température de plaquettes de silicium. Pendant l'activation, une tension de polarisation variant entre 125V et 280V est mesurée entre les plaquettes de silicium et la masse. La présence de cette tension crée une accélération des espèces chargées du plasma en direction desdites plaquettes et un bombardement des surfaces des plaquettes par ces espèces chargées. De plus, après le traitement d'activation et avant leur mise en contact, les plaquettes sont nettoyées dans une solution de type RCA-1 ($NH_3$ : $H_2O_2$ : $H_2O$, 70°C) et/ou dans de l'eau déionisée, et sont séchées. Après la mise en contact, les structures collées subissent un traitement thermique à une température de 100°C, pendant 2 heures. Les résultats reportés dans cet article montrent que les énergies de surface des structures collées selon un procédé comportant une étape préalable de traitement plasma couplé à une gravure ionique réactive sont plus élevées que celles des structures directement collées après un nettoyage chimique.

Dans le brevet US5503704, le collage de deux surfaces est obtenu en formant une couche nitrurée sur une des deux surfaces afin de la rendre à la fois hydrophile et réactive à faible température. Lorsque le matériau de la surface est non azoté, par exemple en silicium, la couche nitrurée est formée par dépôt chimique en phase vapeur assistée par un plasma de $NH_3$ (PECVD), après un nettoyage standard de type RCA, un rinçage à l'eau déionisée et un séchage. Le matériau ainsi traité est ensuite mis en contact avec une autre surface hydrophile et réactive, puis l'ensemble est traité thermiquement à une température de l'ordre d'environ 300°C.

Bien que les techniques d'activation mentionnées ci-dessus permettent d'obtenir des procédés de collage à basse température, avec des énergies de cohésion au moins équivalentes à celles des procédés de collage à haute température, elles ne permettent pas d'obtenir des interfaces de collage moléculaire sans défaut. En particulier, le brevet US5503704 mentionne la présence de défauts dans le substrat, générés par le dépôt du film en $Si_3N_4$.

**Objet de l'invention**

L'invention a pour but un procédé de collage direct de deux plaques comprenant chacune en surface une couche mince en oxyde de silicium ou en silicium, permettant d'obtenir une interface de collage présentant un nombre de défauts significativement réduit par rapport aux procédés de collage selon l'art antérieur, et avantageusement exempte de défaut, en particulier quelle que soit la température appliquée (en particulier comprise entre la température ambiante et 1300°C) à la structure formée par les deux plaques collées.

Selon l'invention, ce but est atteint par les revendications annexées. En particulier, ce but est atteint par le fait qu'avant la mise en contact des couches minces respectives des deux plaques, la couche mince d'au moins une plaque est soumise à une étape unique de traitement de surface, formant un film mince superficiel d'oxynitrure de silicium d'une épaisseur inférieure à 5nm, au moyen d'un seul plasma à base d'azote généré par une source plasma à couplage inductif et en présence d'une différence de potentiel inférieure à 50V entre le plasma et un porte-substrat supportant ladite plaque.

**Description sommaire des dessins**

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- la figure 1 représente, sous forme de schéma-blocs, différentes étapes d'un mode particulier de réalisation d'un procédé de collage selon l'invention.
- les figures 2 à 4 représentent, schématiquement et en coupe, les différentes étapes pour réaliser une structure collée selon le mode particulier de réalisation représenté sur la figure 1.
- les figures 5 et 6 représentent respectivement l'évolution de $\Delta\rho/\rho_{Si}$ en fonction de la profondeur z, à température ambiante, dans une structure collée de deux plaques en silicium, obtenue par un mode particulier de réalisation d'un collage selon l'invention et par un procédé de collage selon l'art antérieur.
- la figure 7 représente le spectre infrarouge d'un film mince d'oxynitrure de silicium formé lors d'un mode particulier de réalisation selon l'invention et le spectre infrarouge d'un film mince d'oxyde de silicium formé lors d'un procédé de collage selon l'art antérieur, à température ambiante.

**Description de modes particuliers de réalisation**

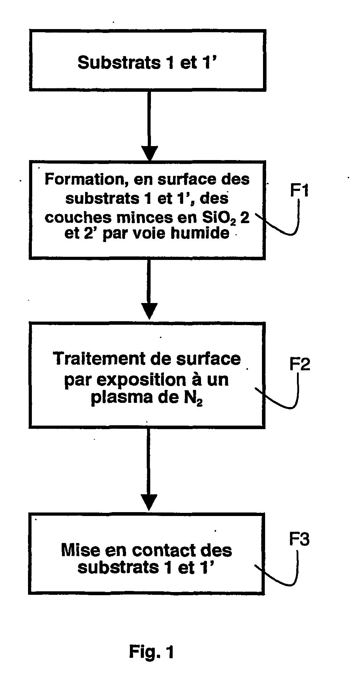

Selon un mode particulier de réalisation représenté sur les figures 1 à 4, deux substrats 1 et 1' en silicium, également appelés plaquettes de silicium, sont collés en réalisant successivement :

- une étape F1 permettant de former par voie humide, en surface des substrats 1 et 1', une couche mince en oxyde de silicium 2 et 2',
- une étape F2 de traitement de surface transformant au moins une partie de la couche mince en oxyde de silicium préalablement formée à l'étape F1, en un film mince superficiel d'oxynitrure de silicium 3 et 3'
- et une étape F3 de mise en contact des deux substrats 1 et 1'.

La formation de la couche mince superficielle 2 et 2' est, avantageusement, réalisée par un nettoyage de type CARO suivi d'un nettoyage de type RCA comprenant une première phase de type SC1 et une seconde phase de type SC2. Le nettoyage de type CARO est un nettoyage dans un bain d'acide appelé CARO ($H_2SO_4$ + $H_2O_2$). La première phase (SC1 ou « Standard Cleaning 1 ») et la seconde phase (SC2 ou « Standard Cleaning 2 ») du nettoyage de type RCA consistent, respectivement, en un nettoyage à l'aide d'une solution alcaline telle que $NH_4OH$ + $H_2O_2$ + $H_2O$ et en un nettoyage à l'aide d'un agent oxydant puissant tel que HCl + $H_2O_2$ + $H_2O$. Les couches minces en oxyde de silicium 2 et 2' ainsi formées présentent l'avantage d'être sans défaut. Ainsi, à ce stade du procédé, la surface de chaque substrat 1 et 1', formée par la surface libre de la couche en oxyde de silicium 2 et 2', est hydrophile.

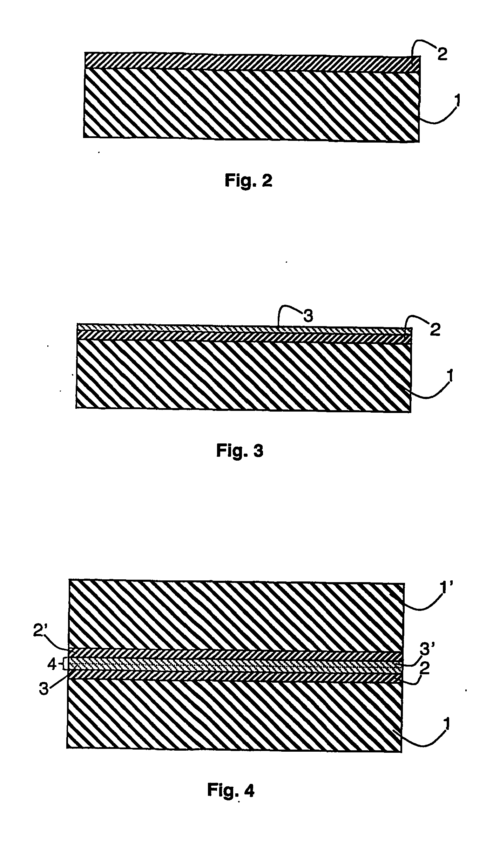

Comme représenté sur les figures 1 et 3, entre l'étape F1 de nettoyage et l'étape F3 de mise en contact des substrats 1 et 1', une étape unique F2 de traitement desdites surfaces, également appelée étape d'activation, est réalisée. Celle-ci permet de former, dans la couche mince en oxyde de silicium 2 et 2' de chaque substrat 1 et 1', un film mince superficiel 3 et 3' en oxynitrure de silicium, d'une épaisseur inférieure à 5nm et avantageusement de l'ordre de 2nm.

Pour cela, la surface libre de la couche mince en oxyde de silicium 2 et 2' de chaque substrat 1 et 1' est exposée, en une seule étape, à un plasma d'azote, généré par une source plasma à couplage inductif (également appelé ICP).

Les substrats 1 et 1' peuvent être exposés au plasma d'azote, simultanément ou successivement. Dans ce dernier cas, les conditions du traitement de surface subi par les deux substrats 1 et 1' peuvent être les mêmes ou différentes. De plus, l'exposition du ou des substrats 1 et 1', au plasma d'azote, peut être réalisée en une ou plusieurs fois.

Par plasma d'azote, on entend un plasma d'azote pur. Cependant, de manière plus générale, le plasma auquel sont exposés les substrats 2 et 2' peut également être un plasma à base d'azote, c'est-à-dire un plasma dont le gaz réactif est l'azote, ce qui n'exclut pas la présence éventuelle dans le plasma d'un gaz porteur comme l'argon ou d'autres gaz en quantité résiduelle. En particulier, d'autres gaz, en faibles quantités, peuvent être présents dans le plasma à base d'azote, dans la mesure où ils n'empêchent pas la formation du film mince superficiel en oxynitrure de silicium. Le plasma peut par exemple comporter de l'oxygène, de l'hydrogène et/ou de l'eau. La concentration de ces autres gaz est de l'ordre de quelques pourcents et, plus particulièrement, inférieure à 5%.

De manière générale, le film mince superficiel en oxynitrure de silicium peut contenir des espèces chimiques comme de l'hydrogène ou de l'oxygène par exemple, en faible quantité. Ainsi, la formule générale de l'oxynitrure de silicium est avantageusement $Si_zO_xN_yH_w$. Ces espèces chimiques peuvent être présentes de façon résiduelles dans l'enceinte de traitement de surface ou bien être introduites sous forme de gaz dans le plasma ou bien encore être présentes au niveau du film mince superficiel traité.

Sur les figures 3 et 4, l'oxynitruration des couches minces de surface en oxyde de silicium 2 et 2' est partielle. Ainsi, l'épaisseur des films minces superficiels 3 et 3' est inférieur à l'épaisseur initiale des couches minces en oxyde de silicium 2 et 2'. Cependant, dans une variante de réalisation, l'oxynitruration d'au moins une couche mince en oxyde de silicium 2 et/ou 2' peut être totale. De plus, une partie du silicium sous-jacent peut également être consommée lors de cette étape. Ainsi, une partie du silicium des substrats 1 et 1', disposée sous la couche mince en oxyde de silicium 2 et 2', peut également être transformée en oxynitrure de silicium.

Par ailleurs, la différence de potentiel entre le plasma et le porte-substrat est faible. Elle est, en particulier, inférieure à 50V, avantageusement inférieure à 15V et, plus particulièrement nulle ou quasi-nulle. Cette différence de potentiel correspond en particulier à une énergie des espèces chargées au niveau de la plaque en particulier inférieure à 50eV, et avantageusement inférieure à 15eV et plus particulièrement nulle ou quasi-nulle. Ainsi, les espèces chargées du plasma d'azote ou à base d'azote ne sont pas accélérées vers la surface du ou des substrats à traiter.

Selon l'invention, la formation du film mince superficiel d'oxynitrure de silicium est réalisée en une étape de traitement de surface, unique et courte, à l'aide d'un seul plasma (plasma à base d'azote). Cette étape permet tout de même d'obtenir un film mince d'oxynitrure d'une épaisseur inférieure à 5nm, c'est-à-dire un film contenant non seulement de l'azote et du silicium mais également de l'oxygène. L'oxygène présent dans le film mince superficiel formé selon l'invention peut, en particulier, provenir d'une quantité d'oxygène contenue dans le plasma à base d'azote et/ou de l'oxygène éventuellement présent dans la couche mince sous-jacente et/ou de l'oxygène résiduel dans l'enceinte utilisée pour réaliser l'étape de traitement de surface. Ainsi, le film mince superficiel selon l'invention n'est pas formé, comme dans l'article « Formation of silicon on plasma synthesized SiOxNy and reaction mechanism » de Ming Zhu et al. (Applied Surface Scienccce 243 (2005) 89-95), en deux étapes successives, consistant respectivement à une nitruration (à l'aide d'un plasma d'azote), puis à une oxydation (par exemple à l'aide d'un plasma d'oxygène). Ceci permet d'obtenir un oxynitrure de silicium fin, présentant une interface avec le silicium ayant de bonnes propriétés électroniques et une bonne nitruration de surface. Or, dans l'article de Ming Zhu et al., il est proposé de réaliser un oxynitrure de silicium d'une épaisseur de l'ordre de 80nm, afin de remplacer l'oxyde enterré d'un substrat en silicium sur isolant (SOI) et d'améliorer la dissipation de chaleur par le substrat.

Par ailleurs, en choisissant une différence de potentiel entre le plasma et le porte-substrat inférieure à 50V, avantageusement inférieure à 15V et de préférence nulle, le nombre de défauts présents à l'interface de collage est considérablement réduit, voire nul.

Enfin, l'étape F3 représentée sur la figure 1 consiste à mettre en contact direct les surfaces libres des deux films minces superficiels 3 et 3'. Cette étape peut être réalisée in situ, c'est-à-dire dans l'enceinte où est réalisé le traitement de surface de l'étape F2 ou bien elle peut être réalisée ex-situ. De plus, cette étape F3 peut être réalisée directement après l'étape F2, c'est-à-dire sans étape intermédiaire entre les deux étapes F2 et F3. Dans des variantes de réalisation, une ou plusieurs étapes intermédiaires peuvent être réalisées entre les étapes F2 et F3, par exemple pour enlever les particules ou une éventuelle contamination (métallique ou hyrocarbure...) déposées lors de l'étape F2 ou ultérieurement à l'étape F2. Ces étapes intermédiaires peuvent, par exemple, comprendre des étapes de traitements de surface, chimiques ou classiquement utilisés dans le domaine de la microélectronique. À titre d'exemple, les substrats 1 et 1', munis des films minces superficiels 3 et 3', peuvent être plongés dans un bain chimique assisté ou non par des mégasons ou bien ils peuvent subir un ou plusieurs brossages, un ou plusieurs traitements thermiques sous atmosphère contrôlée et/ou un ou plusieurs traitements aux rayonnements ultraviolets/à l'ozone.

Dans le mode de réalisation représenté sur les figures 1 à 4, le collage de deux substrats en silicium massif est réalisé en formant, en surface de chacun des deux substrats, un film mince superficiel d'oxynitrure de silicium 3 et 3'. Cependant, le procédé de collage selon l'invention n'est pas limité au mode de réalisation représenté sur les figures 1 à 4.

En particulier, dans le mode spécifique de réalisation représenté sur les figures 1 à 4, des couches minces superficielles d'oxyde de silicium sont formées à la surface des substrats 1 et 1', par voie humide et en particulier par une étape de nettoyage par voie humide. Cependant, au moins une des couches minces superficielles en oxyde de silicium peut être formée par d'autres techniques, seules ou en combinaison. Elle peut, par exemple, être formée par oxydation thermique. Elle peut également être formée par dépôt tel qu'un dépôt chimique en phase vapeur (CVD), un dépôt par pulvérisation par faisceau d'ions (IBS) ou par dépôt par plasma à couplage inductif (ICP). Elle peut aussi être une couche mince d'oxyde de silicium natif, par exemple crée par un traitement de type RCA ou par un traitement par rayonnements UV-ozone ou par un traitement à l'eau ozonée. Ainsi, la mise en contact de deux substrats ou de deux plaques peut, par exemple, être faite avec les combinaisons de couches minces superficielles initiales en oxyde de silicium suivantes :

- $SiO_2$ obtenu par voie humide à coller sur $SiO_2$ obtenu par voie humide,
- $SiO_2$ natif à coller sur $SiO_2$ obtenu par voie humide,
- $SiO_2$ natif à coller sur $SiO_2$ natif,
- $SiO_2$ thermique (par exemple une couche mince d'une épaisseur de l'ordre de 2,5nm à 1 micromètre) à coller sur $SiO_2$ obtenu par voie humide et
- $SiO_2$ thermique (par exemple une couche mince d'une épaisseur de l'ordre de 2,5nm à 25 nm) à coller sur $SiO_2$ natif.
- $SiO_2$ thermique (par exemple une couche mince d'une épaisseur de l'ordre de 2,5nm à 25 nm) à coller sur $SiO_2$ thermique (par exemple une couche mince d'une épaisseur de l'ordre de 2,5nm à 25 nm).

Par ailleurs, le collage peut également être réalisé en ne formant qu'un seul film mince superficiel d'oxynitrure de silicium à la surface d'un seul des deux substrats 1 en silicium. Dans ce cas, avant l'étape de mise en contact, la surface de l'autre substrat 1', destinée à venir en contact avec le film mince superficiel d'oxynitrure de silicium 2 du substrat 1, peut être rendue hydrophile, par création d'une couche mince superficielle en oxyde de silicium, ou bien elle peut être rendue hydrophobe.

En effet, bien que le mode de réalisation représenté sur les figures 1 à 4 consiste en un collage de deux surfaces hydrophiles, le collage direct en utilisant l'activation par plasma à base d'azote peut aussi être réalisé avec au moins une surface hydrophobe. Ainsi, la surface hydrophobe peut être la surface libre d'un des substrats ne subissant pas l'étape d'activation par plasma à base d'azote, lorsqu'un seul film mince superficiel d'oxynitrure de silicium est formé en surface d'un seul des deux substrats. La surface hydrophobe peut aussi être la surface libre du ou d'au moins un des substrats destinés à subir l'étape d'activation par plasma à base d'azote. Dans ce cas, c'est la surface libre en silicium du substrat qui est exposée au plasma à base d'azote généré par une source plasma à couplage inductif. Par ailleurs, dans ce cas, une faible quantité d'oxygène ou d'eau, par exemple présente dans le plasma ou de façon résiduelle dans le bâti, est nécessaire pour permettre la création du film d'oxynitrure de silicium en surface du substrat en silicium. Dans les deux cas, une surface en silicium peut être rendue hydrophobe en réalisant un nettoyage de type CARO, un nettoyage de type RCA et un nettoyage à l'acide fluorhydrique (HF) sous forme liquide ou vapeur. Cette dernière phase de nettoyage permet alors d'éliminer la couche d'oxyde de silicium créée lors du nettoyage de type CARO et RCA.

Enfin, les substrats n'ont pas nécessairement besoin d'être des substrats en silicium massif. Ainsi, dans des variantes de réalisation, au moins un des substrats peut être remplacé par une plaque comportant en surface une couche mince en silicium et/ou une couche mince en oxyde de silicium. À titre d'exemple, la plaque peut être formée par un matériau semi-conducteur différent du silicium, notamment du germanium, par un verre, par un métal et elle comporte, en surface, une couche mince en silicium ou en oxyde de silicium. L'épaisseur de la couche mince en silicium ou en oxyde de silicium est, de préférence, comprise entre quelques nanomètres et quelques micromètres. À titre d'exemple, un substrat en germanium peut comporter en surface une couche mince en silicium et/ou en oxyde de silicium d'une épaisseur comprise entre 3 et 5 mm et avantageusement de 3mm.

Dans tous les cas, une fois les substrats (ou les plaques) mis(es) en contact, l'interface de collage, formée par au moins un film mince superficiel en oxynitrure de silicium, présente un nombre de défauts considérablement réduit par rapport aux procédés de collage selon l'art antérieur. L'interface de collage est, avantageusement, sans défaut. En particulier, elle ne comporte pas de bulle. De plus, cette interface reste de bonne qualité dans le temps, même lorsque la structure collée subit un traitement thermique à une température quelconque allant de la température ambiante jusqu'à 1300°C.

Par ailleurs, la qualité de l'interface de collage est encore améliorée lorsque les conditions opératoires de l'étape d'activation (étape F2 sur la figure 1) permettent d'obtenir un film mince d'oxynitrure de silicium présentant :

- un pourcentage atomique d'azote supérieur à quelques pourcents (par exemple 5%), en particulier à 15% et préférentiellement à 30% et inférieur à 65% et plus particulièrement à 50%,

- une densification électronique, correspondant à la valeur de $\Delta\rho/\rho_{Si}$ = $\dfrac{\cdots}{\rho_{si}}$, où $\rho$ représente la densité d'électrons de l'oxynitrure de silicium et $\rho_{Si}$ représente la densité d'électrons du silicium, supérieure à 10%, préférentiellement supérieure à 15% et encore préférentiellement supérieure à 18%, pour sa valeur maximale sur l'épaisseur de la couche,
- une épaisseur supérieure à 0,1 nm et avantageusement supérieure ou égale à 1nm,
- une très faible concentration de liaisons -OH de surface et de volume
- une concentration de liaisons N-H significative de surface et de volume.

Pour obtenir un film mince superficiel en oxynitrure de silicium présentant ces propriétés, les conditions opératoires pour réaliser l'étape d'activation par plasma d'azote sont avantageusement les suivantes :

- Le ou les substrats sont introduits dans l'enceinte ICP.
- La pression à l'intérieur de l'enceinte avant l'étape de traitement de surface est, de préférence, inférieure à $10^{-3}$ millitorrs (mT), soit environ 0,1333 mPa.
- L'activation plasma se fait, avec une pression partielle d'azote inférieure ou égale à 40mT (soit environ 5,33 Pa) et avantageusement de l'ordre de 5mT (soit environ 0,66 Pa), pendant un temps très court. Ainsi, la pression partielle en azote, pendant le traitement de surface, est, de préférence, inférieure ou égale à 6 Pa et avantageusement inférieure ou égale à 1 Pa. De plus, la durée du traitement de surface est avantageusement inférieure à 5 minutes et préférentiellement inférieure à 2 minutes. Elle est, en particulier, comprise entre 30 secondes et 90 secondes.
- La température du porte-substrat destiné à supporter le ou les substrats à traiter est, avantageusement, supérieure à la température ambiante. Ainsi, le porte-substrat peut être maintenu à une température fixe dont la valeur est comprise dans la gamme 150°C-350°C.
- La source plasma à couplage inductif comprend un générateur de puissance radiofréquences dont la puissance peut être de quelques centaines de watts et préférentiellement entre 500 W et 800W.

À titre d'illustration, des essais ont été réalisés avec des substrats en silicium, d'une épaisseur de 750 microns et de 200mm de diamètre, présentant initialement une surface libre hydrophile (angle de mouillage d'une goutte d'eau < 5°). Ainsi, les exemples 1 à 7, dont certaines conditions opératoires sont reportées dans le tableau ci-dessous, correspondent chacun à un procédé de collage entre deux substrats, ayant chacun été soumis à un nettoyage et à une exposition dans un plasma d'azote généré dans des conditions diverses par une source ICP, avant leur mise en contact.

L'enceinte dans laquelle est réalisé le traitement de surface pour les exemples 1 à 7 est un dispositif commercialisé par la société Applied Materials sous le nom AMAT Centura DPS+. De plus, pour tous les exemples 1 à 7, les conditions opératoires ci-dessous ont été appliquées :

- différence de potentiel entre le porte-substrat et la masse : nulle
- pression à l'intérieur de l'enceinte avant l'étape d'activation plasma : $10^{-3}$ mT
- pression partielle en azote pendant l'étape d'activation plasma : 5 mT
- flux d'azote pendant l'étape d'activation plasma : 100sccm.

| | Ex 1 | Ex 2 | Ex 3 | Ex 4 | Ex 5 | Ex 6 | Ex 7 |
|---|---|---|---|---|---|---|---|
| Type de nettoyage | Caro + RCA (SC1+ SC2) | Caro + RCA (SC1+ SC2) | Caro + RCA (SC1+ SC2) | Caro + RCA (SC1+ SC2) + HF | Caro + RCA la (SC1+ SC2) | Caro + RCA (SC1+ SC2) | Caro + RCA (SC1+ SC2) |
| Puissance source RF (en W) | 800 | 800 | 800 | 800 | 500 | 800 | 800 |
| T° du porte-substrat (en °C) | 250°C | 250°C | 250°C | 250°C | 250°C | 150°C | 350°C |
| Temps d'exposition (en s) | 60 | 30 | 90 . | 60 | 60 | 60 | 60 |

Avant l'étape d'activation plasma, tous les substrats ont été nettoyés avec un nettoyage de type Caro, puis de type RCA (SC1 et SC2). Par contre, les substrats de l'exemple 4 ont ensuite été soumis à un traitement à l'acide fluorhydrique afin d'obtenir une surface hydrophobe et un retrait d'oxyde en surface. Les autres conditions du traitement de surface dans l'exemple 4 sont identiques à celle de l'exemple 1. Les conditions opératoires des exemples 2 et 3 sont identiques à celle de l'exemple 1 à l'exception du temps d'exposition des substrats au plasma d'azote, qui est de 60s dans l'exemple 1, de 30s dans l'exemple 2 et de 90s dans l'exemple 3. Les conditions opératoires de l'exemple 5 sont identiques à celles de l'exemple 1, à l'exception de la puissance du générateur de radiofréquences qui est de 500W dans l'exemple 5 et de 800W dans l'exemple 1. Les conditions opératoires des exemples 6 et 7 sont identiques à celles de l'exemple 1, à l'exception de la température du porte-substrat qui est de 250°C dans l'exemple 1, de 150°C dans l'exemple 6 et de 350°C dans l'exemple 7.

Les films minces superficiels formés dans les substrats ainsi que les interfaces de collage obtenues après la mise en contact de deux substrats ont été caractérisés par différentes techniques d'analyse telles que la spectroscopie de photo-émission XPS, la réflectivité des rayons X (XRR), par spectroscopie infrarouge à transformée de Fourrier (FTIR) et par microscopie acoustique à balayage (SAM).

Les différentes analyses réalisées prouvent la présence d'un film d'oxyde de silicium nitruré. Ainsi, la composition des films obtenus dans les exemples 1 et 4 a été caractérisée par spectroscopie de photoémission X (XPS) couplée à l'enceinte de traitement plasma. Les mesures réalisées pour les substrats traités selon l'exemple 1 ont révélé la présence d'un film mince de $Si_{48}N_{38}O_{14}$ (seules les espèces majoritaires Si, O et N ont été quantifiées) stable dans le temps. Pour l'exemple 4, les mesures ont également révélé la présence d'un film mince de $Si_{48}N_{45}O_7$ stable dans le temps.

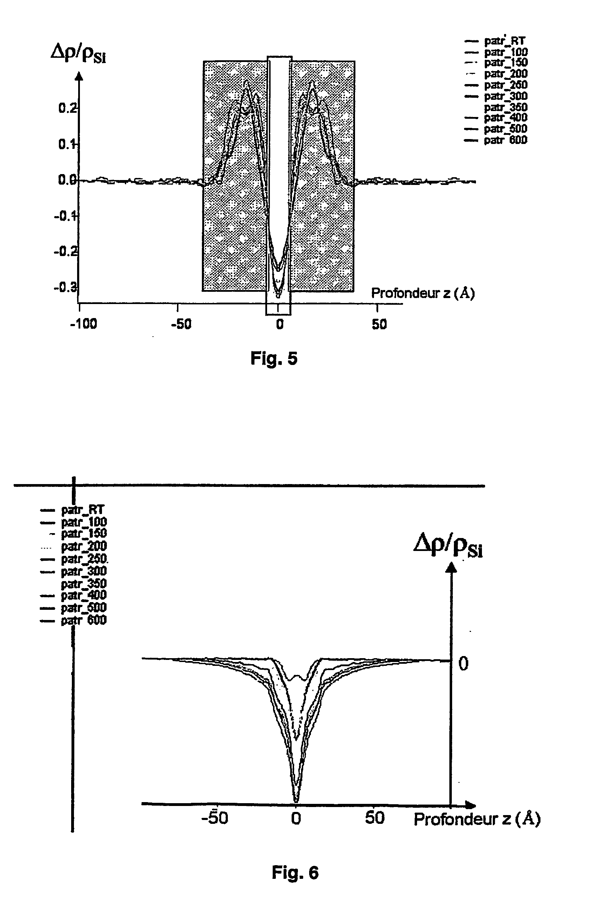

Des analyses par réflectivité X à haute résolution (HR-XRR) permettent de déterminer que, pour les exemples 1 et 2, le film mince d'oxynitrure de silicium de chaque substrat a une épaisseur d'environ 2nm. On constate également une augmentation de la densité d'électrons du film formé lors de l'exposition au plasma d'azote, par rapport à la densité du silicium. A titre d'exemple, la valeur maximale $\Delta\rho/\rho_{Si}$ du film formé dans l'exemple 1 est d'au moins 18% tandis que dans l'exemple 2, elle est d'au moins 20%. Cette augmentation de la densité d'électrons est, en particulier, illustrée sur les figures 5 et 6 qui correspondent à l'évolution de $\Delta\rho/\rho_{Si}$ en fonction de la profondeur z dans une structure collée de deux substrats en silicium obtenue respectivement par un procédé de collage selon l'exemple 1 et par un procédé de collage selon l'art antérieur, comprenant les mêmes conditions que celles de l'exemple 1 pour l'étape de nettoyage mais sans réaliser l'étape d'activation par plasma. Les valeurs de densité d'électrons p en fonction de la profondeur et pour différentes températures sont obtenues par réflectivité par rayons X (XRR) comme rapporté dans l'article « High-energy x-ray reflectivity of buried interfaces created by wafer bonding » de F. Rieutord et al. (Physical review B, Volume 63, 125408). La figure 5 permet également de mesurer l'épaisseur de chaque film.

De plus, pour tous les films formés selon les exemples 1 à 7, l'analyse par microscopie acoustique (SAM avec résolution latérale d'environ $\pm 30\mu m$.) permet de constater que l'interface de collage de deux substrats collés ne présente aucun défaut (absence de bulle) et stable en température, quelle que soit la température d'un éventuel recuit réalisé après collage et notamment dans une gamme de température allant de la température ambiante jusqu'à 1300°C.

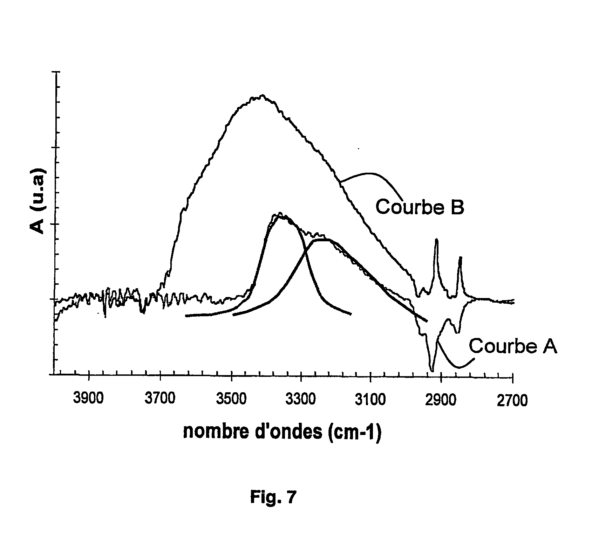

Par spectroscopie FTIR-MIR, on constate l'absence de liaison -OH de surface et de volume pour tous les films réalisés selon les exemples 1 à 7 et la présence de liaisons -N-H. À titre d'exemple, la figure 7 représente le spectre FTIR (courbe A) à température ambiante du film mince d'oxynitrure de silicium formé dans l'exemple 1 et le spectre FTIR (courbe B) d'un film d'oxyde de silicium formé lors d'un procédé de collage selon l'art antérieur (dans les conditions de nettoyage de l'exemple 1 mais sans activation avec un plasma d'azote).

Ainsi, l'activation par plasma d'azote, contrôlée en mode ICP avec une différence de potentiel faible, voire avantageusement nulle entre le plasma et le porte-substrat et la masse, est une technique de traitement de surface permettant des collages ne présentant pas de défaut de collage dans une large gamme de température de recuit après collage.

L'activation par plasma d'azote, contrôlée en mode ICP, a déjà été utilisée dans d'autres domaines pour réaliser des films en oxynitrure de silicium. À titre d'exemple, l'article « Mechanism of Plasma Nitridation of Silicon Dioxide Employing Surface-Wave and Inductively Coupled Plasma Sources » de Hideo Kitagawa (Japanese Journal of Applied Physics, Vol 46, n°8A, 2007, p5304-5312) rapporte l'emploi de ce traitement de surface pour réaliser des films d'oxynitrure de silicium comme diélectriques de grille dans les transistors MOSFET.

Par contre, selon l'invention, un tel traitement de surface est utilisé dans un procédé de collage de deux plaques et, en l'associant à une différence de potentiel faible ou nulle entre le porte-substrat et le plasma, il permet d'améliorer de manière significative la défectivité de l'interface de collage (absence de défaut quelle que soit la température de recuit après collage). En particulier, cette amélioration est obtenue par la création d'au moins un film mince superficiel en oxynitrure de silicium d'une épaisseur d'au moins quelques dixièmes de nanomètres et inférieure à 5nm, ce qui permet d'augmenter la densité d'électrons (densification électronique) en subsurface de la plaque.

Par ailleurs, le procédé de collage selon l'invention peut, avantageusement, être appliqué conjointement à un procédé utilisé pour réaliser des substrats silicium sur isolant (SOI) collés et comprenant une étape d'implantation ionique de gaz avant la mise en contact des deux substrats. Un tel procédé, également connu sous le nom « SmartCut™ », est décrit dans la demande de brevet EP-A-0533551. Le procédé de collage selon l'invention peut aussi être appliqué conjointement à un procédé dit BESOI (respectivement BSOI), également connu sous le nom anglo-saxon « Bond- and Etch-Back Silicon on Insulator » (respectivement « Bonded Silicon on Insulator ») et permettant de réaliser par exemple des structures empilées à couches monocristallines sur des couches d'oxyde enterrées.

**Revendications**

1. Procédé de collage direct de deux plaques comprenant chacune en surface une couche mince en oxyde de silicium ou en silicium, **caractérisé en ce qu'**avant la mise en contact des couches minces respectives des deux plaques, la couche mince d'au moins une plaque est soumise à une étape unique de traitement de surface, formant un film mince superficiel d'oxynitrure de silicium d'une épaisseur inférieure à 5nm, au moyen d'un seul plasma à base d'azote généré par une source plasma à couplage inductif et en présence d'une différence de potentiel inférieure à 50V entre le plasma et un porte-substrat supportant ladite plaque.

2. Procédé selon la revendication 1, **caractérisé en ce que** la différence de potentiel est inférieure à 15V.

3. Procédé selon la revendication 2, **caractérisé en ce que** la différence de potentiel est nulle.

4. Procédé selon l'une quelconque des revendications 1 à 3, **caractérisé en ce que** la durée du traitement de surface est inférieure à 5 minutes.

5. Procédé selon la revendication 4, **caractérisé en ce que** la durée du traitement de surface est comprise entre 30 secondes et 90 secondes.

6. Procédé selon l'une quelconque des revendications 1 à 5, **caractérisé en ce que** le porte-substrat est maintenu à une température comprise entre 150°C et 350°C pendant le traitement de surface.

7. Procédé selon l'une quelconque des revendications 1 à 6, **caractérisé en ce que** la pression partielle en azote, pendant le traitement de surface, est inférieure ou égale à 6 Pa.

8. Procédé selon la revendication 7, **caractérisé en ce que** la pression partielle en azote, pendant le traitement de surface, est inférieure ou égale à 1 Pa.

9. Procédé selon l'une quelconque des revendications 1 à 8, **caractérisé en ce que** la couche mince en oxyde de silicium d'au moins une plaque est une couche mince en oxyde de silicium natif.

10. Procédé selon l'une quelconque des revendications 1 à 8, **caractérisé en ce que** la couche mince en oxyde de silicium d'au moins une plaque est formée par voie humide.

11. Procédé selon l'une quelconque des revendications 1 à 8, **caractérisé en ce que** la couche mince en oxyde de silicium d'une plaque est formée par oxydation thermique.

12. Procédé selon l'une quelconque des revendications 1 à 8, **caractérisé en ce que** la couche mince en oxyde de silicium d'une plaque est formée par dépôt.

13. Procédé selon l'une quelconque des revendications 1 à 12, **caractérisé en ce qu'**au moins une des plaques est formée d'un substrat semi-conducteur comportant en surface la couche mince en oxyde de silicium ou en silicium.

14. Procédé selon la revendication 13 **caractérisé en ce que** le substrat semi-conducteur est à base de germanium.

**Claims**

1. Method for direct bonding of two plates each comprising a thin layer made of silicon oxide or silicon at the surface thereof, **characterized in that**, before the contacting step between the respective thin layers of the two plates, the thin layer of at least one plate is subjected to a single surface treatment step forming a superficial thin film of silicon oxynitride with a thickness of less than 5nm, by means of a single nitrogen-based plasma generated by an inductively coupled plasma source and in the presence of a potential difference of less than 50V between the plasma and a substrate holder supporting said plate.

2. Method according to claim 1, **characterized in that** the potential difference is less than 15V.

3. The method according to claim 2, **characterized in that** the potential difference is zero.

4. The method according to any one of claims 1 to 3, **characterized in that** the time of the surface treatment is less than 5 minutes.

5. The method according to claim 5, **characterized in that** the time of the surface treatment is comprised between 30 seconds and 90 seconds.

6. The method according to any one of claims 1 to 5, **characterized in that** the substrate holder is kept at a temperature comprised between 150°C and 350°C during the surface treatment.

7. The method according to any one of claims 1 to 6, **characterized in that** the nitrogen partial pressure during the surface treatment is less than or equal to 6 Pa.

8. The method according to claim 7, **characterized in that** the nitrogen partial pressure during the surface treatment is less than or equal to 1 Pa.

9. The method according to any one of claims 1 to 8, **characterized in that** the thin layer made of silicon oxide of at least one plate is a thin layer of native silicon oxide.

10. The method according to any one of claims 1 to 8, **characterized in that** the thin layer made of silicon oxide of at least one plate is formed by wet process.

11. The method according to any one of claims 1 to 8, **characterized in that** the thin layer made of silicon oxide of one plate is formed by thermal oxidation.

12. The method according to any one of claims 1 to 8, **characterized in that** the thin layer made of silicon oxide of one plate is formed by deposition.

13. The method according to any one of claims 1 to 12, **characterized in that** at least one of the plates is formed by a semi-conductor substrate comprising the thin layer made of silicon oxide or silicon at a surface thereof.

14. The method according to claim 13, **characterized in that** the semi-conductor substrate is germanium-based.


**Patentansprüche**

1. Verfahren zur Direktbindung von zwei Platten, die jeweils an der Oberfläche eine dünne Siliziumoxid- oder Siliziumschicht aufweisen,
   **dadurch gekennzeichnet,**
   **dass** bevor die jeweiligen dünnen Schichten der beiden Platten in Kontakt miteinander gebracht werden, die dünne Schicht mindestens einer Platte einem einfachen Oberflächenbehandlungs-Schritt unterzogen wird, bei dem ein dünner Oberflächenfilm aus Siliziumoxynitrid mit einer Stärke von weniger als 5 nm gebildet wird, und zwar mittels eines einzigen Plasma auf Stickstoffbasis, das durch eine Plasmaquelle mit induktiver Kopplung und mit einer Potentialdifferenz von weniger als 50 V zwischen dem Plasma und einem Substrat-Träger, der diese Platte trägt, erzeugt wird.

2. Verfahren nach Anspruch 1,
   **dadurch gekennzeichnet,**
   **dass** die Potentialdifferenz weniger als 15 V beträgt.

3. Verfahren nach Anspruch 2,
   **dadurch gekennzeichnet,**
   **dass** die Potentialdifferenz gleich Null ist.

**4.** Verfahren nach einem der Ansprüche 1 bis 3,
**dadurch gekennzeichnet,**
**dass** die Dauer der Oberflächenbehandlung weniger als 5 Minuten beträgt.

**5.** Verfahren nach Anspruch 4,
**dadurch gekennzeichnet,**
**dass** die Dauer der Oberflächenbehandlung zwischen 30 Sekunden und 90 Sekunden beträgt.

**6.** Verfahren nach einem der Ansprüche 1 bis 5,
**dadurch gekennzeichnet,**
**dass** der Substrat-Träger während der Oberflächenbehandlung auf einer Temperatur gehalten wird, die zwischen 150 °C und 350 °C beträgt.

**7.** Verfahren nach einem der Ansprüche 1 bis 6,
**dadurch gekennzeichnet,**
**dass** der Stickstoff-Partialdruck während der Oberflächenbehandlung niedriger als oder gleich 6 Pa ist.

**8.** Verfahren nach Anspruch 7,
**dadurch gekennzeichnet,**
**dass** der Stickstoff-Partialdruck während der Oberflächenbehandlung niedriger als oder gleich 1 Pa ist.

**9.** Verfahren nach einem der Ansprüche 1 bis 8,
**dadurch gekennzeichnet,**
**dass** die dünne Siliziumoxyd-Schicht mindestens einer Platte eine dünne Schicht aus purem Siliziumoxyd ist.

**10.** Verfahren nach einem der Ansprüche 1 bis 8,
**dadurch gekennzeichnet,**
**dass** die dünne Siliziumoxyd-Schicht mindestens einer Platte mittels Feuchtigkeit gebildet ist.

**11.** Verfahren nach einem der Ansprüche 1 bis 8,
**dadurch gekennzeichnet,**
**dass** die dünne Siliziumoxyd-Schicht einer Platte durch Wärmeoxidation gebildet ist.

**12.** Verfahren nach einem der Ansprüche 1 bis 8,
**dadurch gekennzeichnet,**
**dass** die dünne Siliziumoxyd-Schicht einer Platte durch Ablagerung gebildet ist.

**13.** Verfahren nach einem der Ansprüche 1 bis 12,
**dadurch gekennzeichnet,**
**dass** mindestens eine der Platten aus einem halbleitenden Substrat gebildet ist, das an der Oberfläche die dünne Siliziumoxyd-Schicht oder Siliziumschicht aufweist.

**14.** Verfahren nach Anspruch 13,
**dadurch gekennzeichnet,**
**dass** das halbleitende Substrat auf Germaniumbasis besteht.

EP 2 304 787 B1

Substrats 1 et 1'

Formation, en surface des
substrats 1 et 1', des
couches minces en SiO$_2$ 2
et 2' par voie humide

F1

Traitement de surface
par exposition à un
plasma de N$_2$

F2

Mise en contact des
substrats 1 et 1'

F3

Fig. 1

11

Fig. 2

Fig. 3

Fig. 4

**Fig. 5**

**Fig. 6**

**Fig. 7**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5503704 A
- EP 0533551 A

**Littérature non-brevet citée dans la description**

- **P. AMIRFEIZ et al.** Formation of silicon structures by plasma-activated wafer bonding. *Journal of the Electrochemical Society,* vol. 147 (7), 2693-2698
- **T. SUNI et al.** Effects of Plasma Activation on Hydrophilic Bonding of Si and SiO. *Journal of the Electrochemical Society,* 2002, vol. 149 (6), G348-G651
- **MING ZHU et al.** Formation of silicon on plasma synthesized SiOxNy and reaction mechanism. *Applied Surface Scienccce,* 2005, vol. 243, 89-95
- **F. RIEUTORD et al.** High-energy x-ray reflectivity of buried interfaces created by wafer bonding. *Physical review B,* vol. 63, 125408
- **HIDEO KITAGAWA.** Mechanism of Plasma Nitridation of Silicon Dioxide Employing Surface-Wave and Inductively Coupled Plasma Sources. *Japanese Journal of Applied Physics,* 2007, vol. 46 (8A), 5304-5312